# EUROPEAN PATENT SPECIFICATION

(11) **EP 1 771 796 B1**
(45) Date of publication and mention of the grant of the patent: **13.04.2022**
(21) Application number: 05738841.5
(22) Date of filing: 10.05.2005
(51) Int. Cl.: G01R 27/28, G01R 31/3183, G01R 31/3193, G01R 31/317

(54) **TESTING SUITE FOR PRODUCT FUNCTIONALITY ASSURANCE AND GUIDED TROUBLESHOOTING**
TESTSUITE ZUR SICHERSTELLUNG VON PRODUKTFUNKTIONALITÄT UND ANGELEITETEN PROBLEMBESEITIGUNG
SYSTEME D'ESSAI POUR GARANTIE DE LA FONCTIONNALITE D'UN PRODUIT ET DIAGNOSTIC DES DEFAILLANCES GUIDE

(30) Priority: 10.05.2004 US 569261 P; 24.08.2004 US 603543 P
(43) Date of publication of application: 11.04.2007
(73) Proprietor: QualiSystems Ltd, 76705 Rechovot (IL)
(72) Inventor: MOSKOVICH, Moshe, 79800 Ezer (IL); ACKERMAN, Alex, 77452 Ashdod (IL)
(74) Representative: Harrison IP Limited
(86) International application number: PCT/IL2005/000495
(87) International publication number: WO 2005/107372

(56) References cited:
- US-A- 5 974 241
- US-A- 6 032 107
- US-A- 6 061 283
- US-B1- 6 510 398

## Description

### FIELD AND BACKGROUND OF THE INVENTION

The present invention relates to functionality testing of manufactured items and, more particularly, but not exclusively to an analyzing and locating faults in manufactured products.

Every product has to be tested to verify that it complies with its functional specifications. The testing is performed on a functional testing platform that is developed by a test engineer for the specific product according to the product's specification received from the product's design team. This process usually consumes weeks and even months, depending on product complexity. The process requires communication between people from different departments, sometimes employed by different companies, and in the global economy, often residing in different countries.

Testing specifications are unique and differ for each and every new product type. The testing platform consists of a specific configuration of hardware instrumentation, usually computer controlled by means of dedicated testing programs. The development of the dedicated testing software is paced by the interaction with the design teams and many other departments such as: quality assurance, manufacturing, integration, testing, maintenance and customer support, etc. Developing an efficient functional testing facility is therefore expensive and time consuming and often slows the deployment of a new product to the market. The continuous reduction of new products life cycle increases the importance of reducing the time it takes to establish effective functional testing facility.

The prior art includes several software programs for managing the execution of functional testing. However, in most cases, dedicated software is developed for functional testing of each and every new product. Therefore there is still a need for an application suite which is not based on writing code and is suitable for performing tests at all stages of product development and manufacturing. The prior art lacks the necessary means to standardize the field of functionality assurance procedures, and does not provide an information continuum between the R&D, testing and manufacturing teams of a given product.

There is thus a widely recognized need for, and it would be highly advantageous to have, a method and a system devoid of the above limitations.

US Patent No. 6,061,283 to Takahashi et al, discloses a semiconductor integrated circuit evaluation system for evaluating, at high speed, functions of a device under test and a test pattern for testing the device under test without using an actual tester or designed device.

US Patent No. 6,032,107 to Hitchcock discloses a method and apparatus to calibrate uncelebrated test equipment using reference devices.

There is thus a widely recognized need for, and it would be highly advantageous to have, a method and a system devoid of the above limitations.

### SUMMARY OF THE INVENTION

The invention is set out in the appended set of claims.

Unless otherwise defined, all technical and scientific terms used herein have the same meaning as commonly understood by one of ordinary skill in the art to which this invention belongs. The materials, methods, and examples provided herein are illustrative only and not intended to be limiting.

Implementation of the method and system of the present invention involves performing or completing certain selected tasks or steps manually, automatically, or a combination thereof. Moreover, according to actual instrumentation and equipment of preferred embodiments of the method and system of the present invention, several selected steps could be implemented by hardware or by software on any operating system of any firmware or a combination thereof. For example, as hardware, selected steps of the invention could be implemented as a chip or a circuit. As software, selected steps of the invention could be implemented as a plurality of software instructions being executed by a computer using any suitable operating system. In any case, selected steps of the method and system of the invention could be described as being performed by a data processor, such as a computing platform for executing a plurality of instructions.

### BRIEF DESCRIPTION OF THE DRAWINGS

The invention is herein described, by way of example only, with reference to the accompanying drawings. With specific reference now to the drawings in detail, it is stressed that the particulars shown are by way of example and for purposes of illustrative discussion of the preferred embodiments of the present invention only, and are presented in order to provide what is believed to be the most useful and readily understood description of the principles and conceptual aspects of the invention. In this regard, no attempt is made to show structural details of the invention in more detail than is necessary for a fundamental understanding of the invention, the description taken with the drawings making apparent to those skilled in the art how the several forms of the invention may be embodied in practice.

In the drawings:
FIG. 1 is a simplified block diagram of a functional testing system according to one preferred embodiment of the present invention;
Fig. 2 is a simplified block diagram of a preferred embodiment of the FTCAM component of the functional testing system of Fig. 1;
Fig. 3 is a simplified flow chart of a preferred embodiment of the procedure executed by the processing engine, which is a component of the FTCAM of Fig. 2;
Fig. 4 is a simplified flow chart of a preferred embodiment of the procedure executed by a user employing the test builder wizard, which is another component of the functional testing system of Fig. 1;
Fig. 5 is a simplified flow chart of a preferred embodiment of the procedure executed by a user, in which the user selects analysis algorithm for analyzing the response signal, while operating the test builder wizard of Fig. 4;
Fig. 6 is a simplified illustration of a preferred embodiment of a graphical user interface display of a preferred embodiment of a test tree pertaining to the test builder wizard of Fig. 4;
Fig. 7 is a simplified block diagram of a functional test planning system and a functional testing system according to another preferred embodiment of the present invention;
Fig. 8 is a simplified illustration of a preferred embodiment of testing an electronic circuit board using the present invention;
Figs. 9, 10 and 11, taken together is a list of preferred algorithms for converting response signals into reference signals;
Fig. 12 is a simplified block diagram of the software for a functional testing system according to a preferred embodiment of the present invention.

### DETAILED DESCRIPTION OF THE PREFERRED EMBODIMENTS

The preferred embodiments provide means for creating a platform of testing and test planning tools for the functional testing environment. The object of the present embodiments is to overcome the shortcomings of prior art referred to above. For example: to replace the need for writing a dedicated code for test programs and to provide the users with an application suite that contains the platform, the tools and the capabilities for creating, managing and executing functional testing programs. Preferably, these tools may also include debugging and troubleshooting capabilities that enable users to perform all levels of tests on the products. The preferred embodiments also provide detailed reports of test results and all necessary tests and program related documentation; the reports may easily be edited, maintained and shared. The present embodiments dramatically reduce the time required to establish test programs additionally provides means for the standardization of product functionality assurance procedures.

The preferred embodiments provide a method and a system to perform the following procedures:
1. Creating a functional test procedure from CAD data
   a. By manually adding stimulus signals and expected response signals
   b. By automatically creating stimulus signals and expected response signals from simulation data.
2. Creating a functional test procedure by recording a response signal of an approved product instance and converting it into a reference signature
3. Preferably creating a troubleshooting procedure using procedures which are similar to 1 or 2 above, and, optionally using the following additional procedures:
   a. Expert guided - the troubleshooting procedure and the recommended sequence of measurements are based on expert knowledge typically acquired from design engineers;
   b. Experience guided - after a fault is located, the cause of that fault is recorded in the system and associated with the measured response signals, to provide future guidance when such response signal is detected again.

On the whole, the present embodiments are useful to support the entire lifecycle of a product and to be used by a variety of professionals involved in the development, manufacturing and maintenance of the product, as described in the following list:
1. Proof of design, by the R&D engineers
2. Quality assurance, by the quality management personnel
3. Final production test, by quality control personnel
4. Integration test of a sub-system or the complete system, by integration personnel
5. Field testing, troubleshooting and maintenance, by field engineers, maintenance laboratory personnel and debuggers
6. Implementation of Engineering Change Orders (ECO), by R&D engineers

The principles and operation of a method and a system for testing a product functionality and preferably also for a guided troubleshooting of the product according to the present invention may be better understood with reference to the drawings and accompanying description.

For the sake of simplicity, whenever applicable, the present invention will be described hereinbelow with respect to testing and troubleshooting of electrical circuit boards.

Before explaining at least one embodiment of the invention in detail, it is to be understood that the invention is not limited in its application to the details of construction and the arrangement of the components set forth in the following description or illustrated in the drawings. The invention is capable of other embodiments or of being practiced or carried out in various ways. Also, it is to be understood that the phraseology and terminology employed herein is for the purpose of description and should not be regarded as limiting.

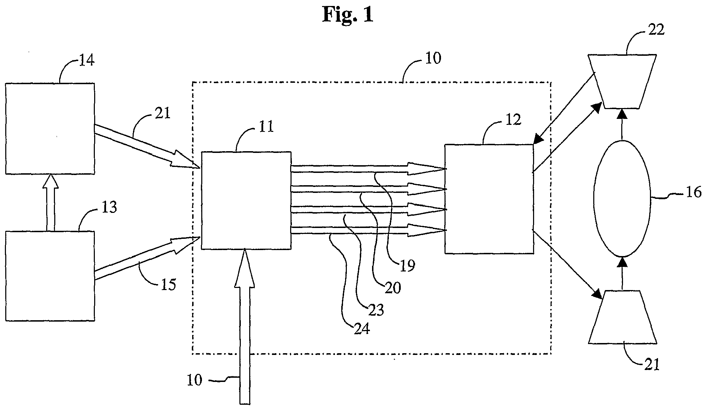

Reference is now made to Fig. 1, which is a simplified block diagram of a functional testing system 10 according to a preferred embodiment of the present invention. The functional testing system 10 provides a method for creating functional test procedure from CAD data, either by manually defining stimulus signals and expected response signals, or by automatically creating stimulus signals and expected response signals from simulation data.

The functional testing system 10 is typically and preferably a software program that can be executed on a common computer, typically and preferably a PC computer. Alternatively the functional testing system 10 can be a computer equipped with the software program. The functional testing system 10 comprises two main elements: a functional test computer aided manufacturing (FTCAM) system 11 and a functional test system (FTS) 12.

The FTCAM 11 connects to external tools, readily available and in common use of design engineers. Such tools are computer aided design (CAD) tool 13 and simulation tool 14. Though only one CAD tool and only one simulation tool are shown in Fig. 1, it should be understood that each type of tools represents a variety of such tools, such as electrical CAD tool, mechanical cad tool, etc. For example, regarding the design of electronics circuitry boards, there are electrical design tools and board layout design tools.

The FTCAM 11 receives from the CAD tools 13 design information 15 pertaining to the construction and configuration of the product to be tested 16. Typical design information may comprise part lists, net lists, electrical schematics, mechanical schematics, etc.

The FTCAM 11 receives from the simulation tools 14 information pertaining to the product's specifications and the results of the simulations resulting from various inputs and testing conditions. The information received from the simulation tools 14 is referred to hereinbelow as simulation information and referenced by numeral 17.

Optionally, the FTCAM 11 receives from a design engineer additional design information 18 to complement the design information 15 and the simulation information 21 to provide the FTCAM 11 with a complete set of information about the testing conditions and requirements. The additional design information 18 typically comprises tolerance values for expected measurements, information pertaining to the designers' experience, and information regarding relevant standards.

The FTCAM 11 converts the design information 15 and the simulation information 17 into four types of information:
1. Test programs 19, to be executed by the FTS 12.
2. A list 20 of test & measurement devices, such as activation device 21 and measuring device 22, that are to be controlled by the FTS 12 to test the product 16. Though only one activation device and only one measuring device are shown in Fig. 1, it should be understood that each type of devices represents a variety of such. For example, testing of electronic circuit boards may require several power supplies, several analog and digital signal generators and several analog and digital signal analyzers.
3. Mount and wiring diagrams 23 connecting the product 16 to the test and measurement devices 21 and 22.
4. Test environment diagram 24.

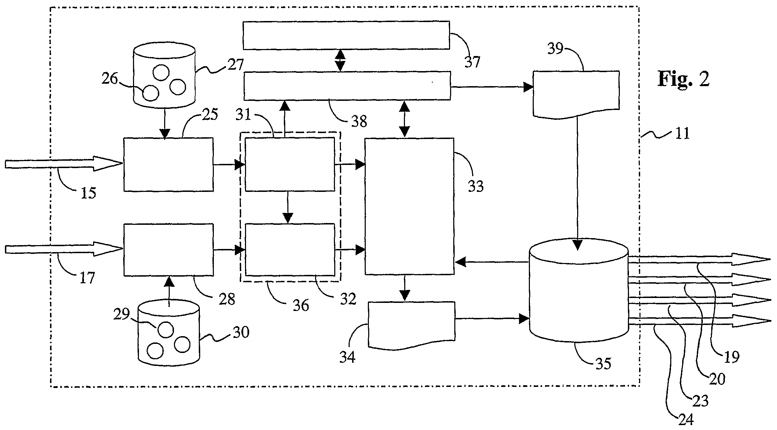

Reference is now made to Fig. 2, which is a simplified block diagram of a preferred embodiment of the FTCAM 11. Typically and preferably, the FTCAM 11 receives the design information 15 into a CAD format analyzer module 25 that translates the received information from the proprietary CAD format into a generic FTCAM format according to a selected CAD format converter 26 stored in the database of CAD format converters 27. The FTCAM 11 also receives the simulation information 17 into a simulation format analyzer module 28, that translates the received information from the proprietary simulation tool's format into a generic FTCAM format, according to a selected simulation format converter 29 stored in the database of CAD format converters 30. The CAD information and the simulation information are then processed by a CAD processing engine 31 and a simulation processing engine 32, respectively, to provide input to a test builder wizard 33, to create test procedures 34 and store them in the database 35, where they are made available to the FTS 12. The CAD information provides information pertaining to the structure of the product while the simulation information provides information pertaing to preferred input signals and their respective output signals. Combining the CAD information and the simulation information, preferably with additional information provided by design engineers, and employing the test builder wizard, the user can create specific test procedures. Preferably the user creates the test procedures by selecting algorithms from a pool of predefined algorithms and modifying the required algorithm's parameters. Thus, a reference signal, or signature, is created and the test procedure analyses the response signal received from the tested product and compares it with the relevant reference signal. The wizard is both able to advise the user what tests to put in and what measurements to expect at the output.

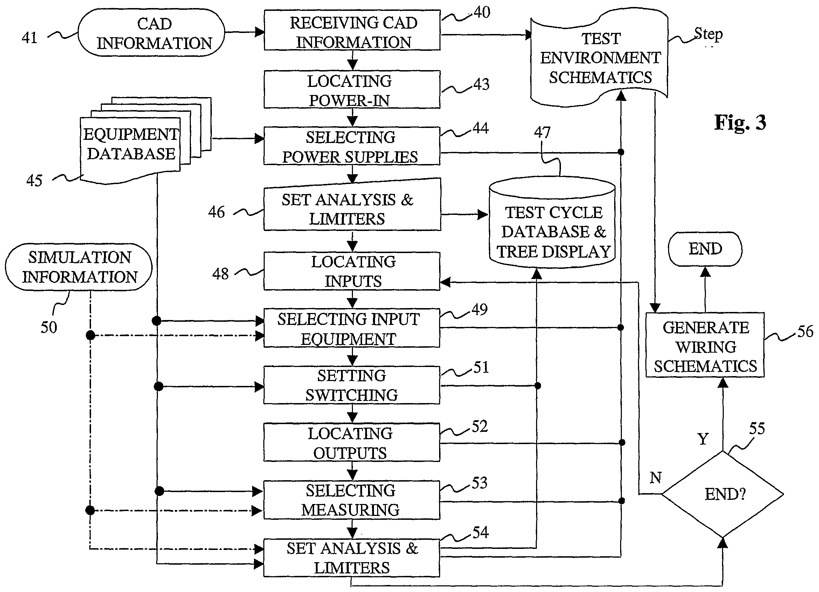

The CAD processing engine 31 and the simulation-processing engine 32 are referred to hereinbelow as a processing engine 36, further explained with reference to Figs. 3, 4 and 5.

A test designer can now employ a graphical user-interface module 37, to operate a graphical editor processor module 38, and manipulate the test builder wizard affecting the resulting test procedures, additionally resulting in the creation of functional schematics 39, also stored in the database 35, and available for use by the FTS 12.

The FTCAM system receives as an input design reference data generated by design simulation tools, design data generated by CAD systems and additional design information provided by design engineers, typically pertaining to testing conditions. The FTCAM processes this data and generates computer executable software containing complete testing procedures, including control command to activation devices to produce the required stimuli (e.g. as defined by the simulation information), control command to measurement devices to measure the response signals resulting from these stimuli, and the reference specifications to which the measured response signal are compared to assess the tested product compliance with the functional requirements.

Reference is now made to Fig. 3, which is a simplified flow chart of a preferred embodiment of the procedure executed by the processing engine 36 shown in Fig. 2. As an example of the operation of the procedure, the procedure is described hereinbelow with respect to processing of CAD and simulation information pertaining to an electronic circuit board. Typically an electronic circuit board has power-in lines, analog inputs, digital inputs, analog outputs, digital outputs, all typically distributed at the edges of the board, and test points that are typically distributed on the surface of the board.

The process starts in step 40 of Fig. 3 by receiving CAD information 41, recovering inputs, outputs and connectors, and displaying the information to the user (Step 42).

The procedure proceeds to step 43 to locate the power-in lines in the CAD information, particularly in the net list.

The procedure proceeds to step 44 to select from an equipment database 45 the appropriate power supply to deliver the required activation power to the located power-in lines. The power supply, optionally and preferably a display of the panel of the power supply, is displayed to the user on the computer's display to enable the user to set the required values.

The procedure proceeds to step 46 to enable the user to select analysis algorithms (as will be further discussed below), set power, voltage and current limits as required, and store these limit values in the database 47. This information is stored in the database 47 for future use by the FTS 12.

The procedure proceeds to step 48 to locate input lines in the CAD information, particularly in the net list.

The procedure proceeds to step 49 to select signal-generating equipment from the equipment database 45, according to the required amplitude and frequency span of the input signals. Optionally and preferably, the selection is also based on simulation information 50, obtained from simulation tools. The selected signal generators, optionally and preferably a display of the operating panel of the signal generators, are then displayed to the user to enable the user to set the values required to stimulate the tested product and to create the response signal.

The procedure proceeds to step 51 to set switching logic to connect the signal generating equipment to the input lines and additionally the switching logic to connect the measuring equipment to the output lines. This information is stored in database 47 for future use by the FTS 12.

The procedure proceeds to step 52 to locate output lines in the CAD information, particularly in the net list.

The procedure proceeds to step 53 to select signal measuring equipment from the equipment database 45, according to the required amplitude and frequency span of the input signals. Optionally and preferably, the selection is also based on simulation information 50,

The procedure proceeds to step 54 to select and set the signal analysis algorithms, as well as the relevant parameters and limiters, that would be required to analyze the measured response signals.

The procedure proceeds to step 55 where the user determines whether a test cycle is completed or whether an additional sub-test should be created. If the test cycle is completed the user proceeds to step 56 to generate a wiring schematics and end the procedure. The wiring schematics is used to create wiring harness to connect the tested product to the power supplies, signal generators and measuring devices that were selected to participate in the specific test cycle.

The information described above, including, but not limited to, the selection of power supplies, signal generators, measuring devices, operating values for the power supplies and signal generators, locations of inputs outputs and test points, switching configurations, etc., is stored in the database 47 for future use by the FTS 12. The information pertaining to the outputs, selected measuring devices and switching settings are then displayed to the user.

Element Step 42 of Fig. 3 provides the interface to the graphical editor processor module 38 and the graphical user-interfacing module 37 of Fig. 2, and the database 47 of Fig. 3 provides interface to the test builder wizard 33.

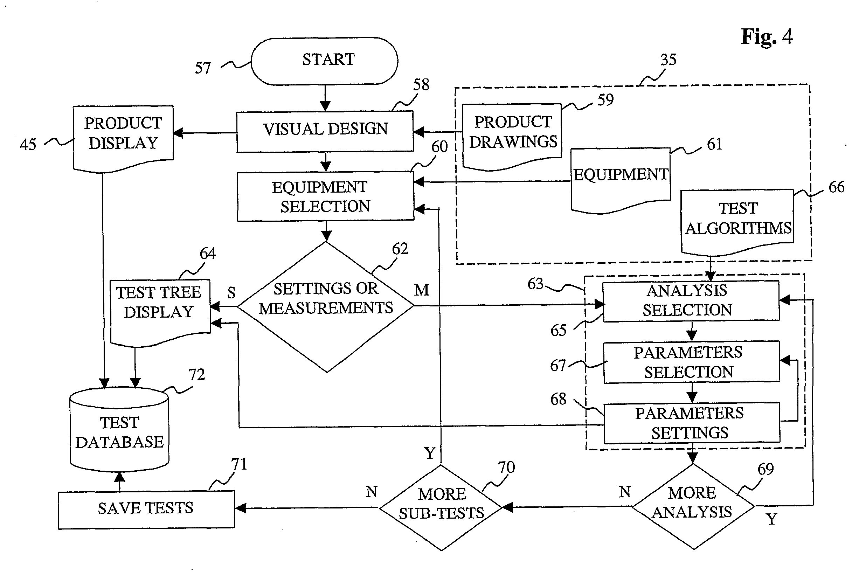

Reference is now made to Fig. 4, which is a simplified flow chart of a preferred embodiment of the procedure executed by a user employing the test builder wizard 33. The procedure start at step 57 and proceeds to step 58 where the user retrieves product drawings 59 received from the CAD systems. In step 60 the user selects activation and measuring equipment 61 from the database 35. The user then proceeds via step 62 to either step 63 to set a specific measurement procedure or to step 64 to set the tree of measurement procedures. Step 63 comprises three sub-steps 65, 67 and 68 as follows: In step 65, the user selects a method of analysis of the measured response signal by selecting a predefined algorithm 66 from the database 35. In step 67, the user selects a parameter that pertains to the measured response signal and the selected algorithm and in step 68 the user sets the parameter. Several parameters can be set for each method of analysis by repeating steps 67 and 68 as necessary. Several algorithms can be combined into a test by repeating steps 65, 67 and 68 through step 69. If all the tests are completed (70) the tests are saved (71) in the database 72 (within database 35).

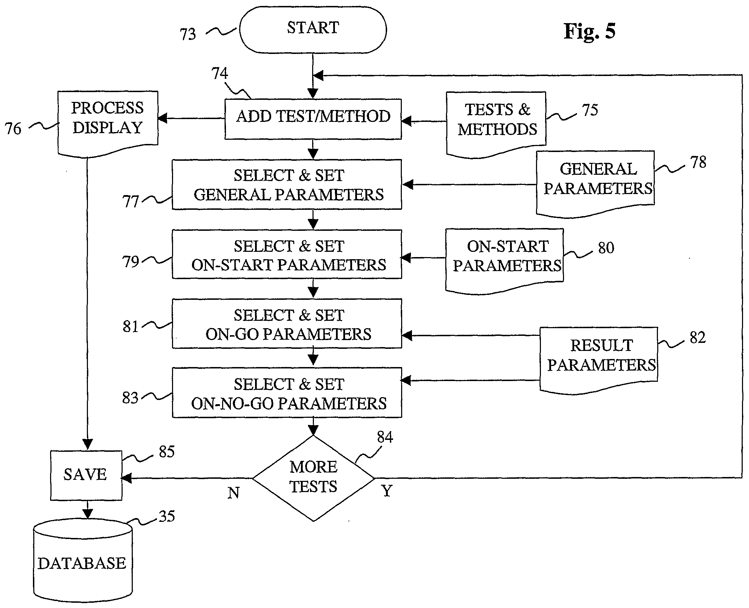

Reference is now made to Fig. 5, which is a simplified flow chart of a preferred embodiment of the procedure executed by a user performing step 63 of Fig. 4 in which the user selects an analysis algorithm for analyzing the response signal.

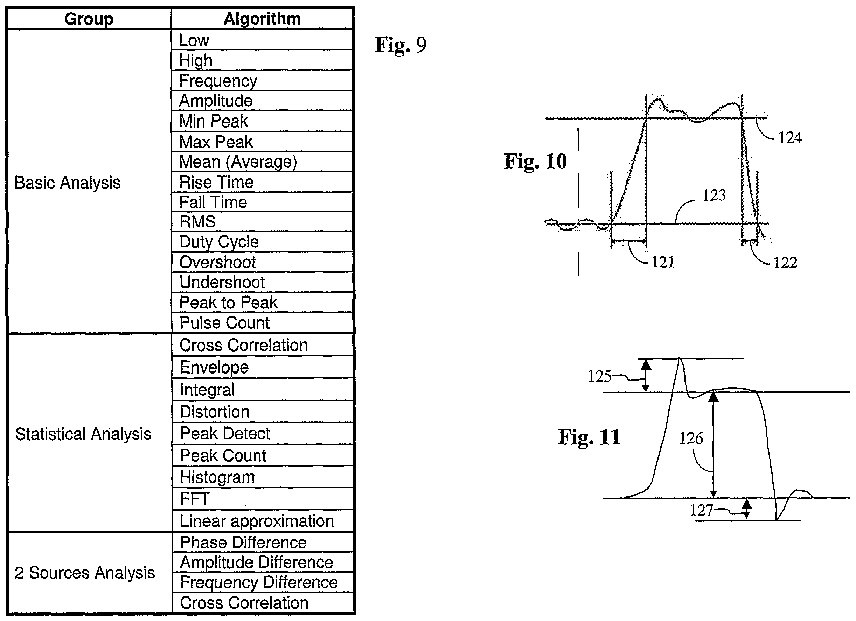

The procedure starts at step 73 and proceeds to step 74 where the user creates a new test, procedure or method by selecting an algorithm template 75 from the database 35. Types of algorithms will be further discussed below with reference to Figs. 9, 10 and 11. The algorithm template is then displayed 76 and configured in steps 77-. In step 77 the user selects and configures general parameters 78. In step 79 the user selects and configures parameters 80 that pertains to the beginning of the test. In step 81 the user selects and configures results parameters 82 that pertains to a GO result, and In step 83 the user selects and configures results parameters 82 that pertains to a NO-GO result. When all tests are created and configured (84) the user saves (85) the tests into the database 35.

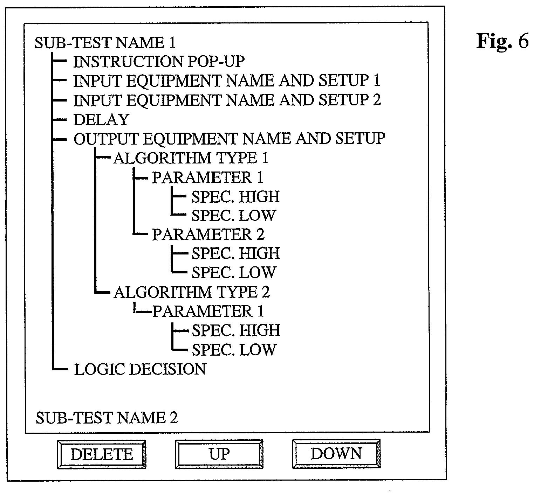

Reference is now made to Fig. 6, which is a simplified illustration of a preferred embodiment of a graphical user interface display of a preferred embodiment of a test tree pertaining to element 64 of Fig. 4. Fig. 6 shows the structure of one sub-test, comprising two units of input equipment (e.g. signal generators), an output equipment (e.g. a measuring device), two algorithms that have been selected to analyze the measured signal and their respective parameters.

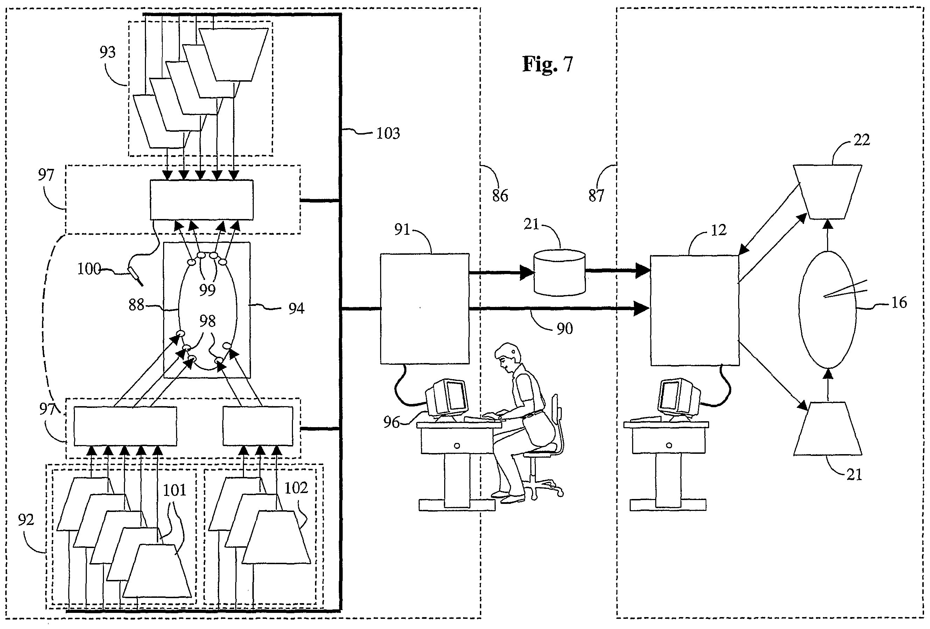

Reference is now made to Fig. 7, which is a simplified block diagram of a functional test planning system 86 and a functional testing system 87, according to another preferred embodiment of the present invention. The functional test planning system 86 is a preferred embodiment of the present invention providing a method for creating a functional test procedure by recording a response signal of an approved product instance 88 and converting it into a reference signature (also named hereinbelow a reference signal). The reference signature and the testing procedure are then transferred to the functional testing system 89 to test further instances 16 of the product. If the further instances are found to correspond to the approved instance then the test is successful. The transfer of the testing procedure and signature from the functional test planning system to the functional testing system, in the case that these are not the same system, can be executed via a shared storage 21, a portable storage (not shown) or via a network 90. The functional testing system 87 is preferably of a similar construction to the functional test planning system 86, and typically is a sub-configuration thereof, meaning that it may comprise only a part of the components of the functional test planning system 86.

The product instance 88 to be tested by the functional test planning system 86 is first approved by the design engineers to be in compliance with the product's specifications and functional requirement and to be an exemplary instance of the product.

The functional test planning system 86 comprises a computer 91, typically and preferably a PC, an array of activation devices 92 and measuring devices 93 and a mount 94 operative to carry the tested product 88 and to connect it to the activation devices and to the measuring devices. The computer 95 comprises a display device 96 to enable a user to operate the functional test planning system 86. A switching matrix 97 is provided to connect selected activation devices to selected locations 98 (inputs) of the tested product 88, and to connect selected measuring devices to other selected locations 99 (outputs) of the tested product 88. Alternatively or additionally, activation devices and measuring devices can be connected to the tested product 88 directly or via a probe 100 The computer 95 controls the activation devices 92 (such as power supplies 101 and signal generators 102), the measuring devices 93 and the switching matrix 97, via control links 103 such as a GPIB, USB, 802.3, 802.11, etc.

To create a reference signature and a test procedure the user preferably performs the following actions:
1. acquire an approved instance of the product to be tested;
2. determine input locations of the tested product 88;
3. select activation devices that are appropriate to operate the tested product and provide the required stimuli to test the product's behavior;
4. determine one or more output location of the tested product 88 where a response signal to the stimulus can be measured;
5. select one or more measurement device that are appropriate to measure the response signal;
6. mount the approved product instance and connects it to the activation devices and the measurement devices via the switching matrix;
7. determine the testing procedure by instructing the activation devices to provide the required stimuli to the tested approved product instance 88;
8. instruct the activation devices to provide the required stimuli and the measurement devices to record the response signals;
9. instruct the computer 95 to convert the response signal into a reference signal (also termed signature or reference signature);
10. provide the testing procedure and the reference signal to the functional testing system 87 to enable the functional testing system 87 to test other instances 16 of the product.

The construction of the functional testing system 87 can be identical to the construction of the functional test planning system 86. Alternatively and preferably, the functional testing system 87 comprises only activation devices and measuring devices that are know to be required to test the product 16.

To test the product 16 to be in compliance with its functional specifications the user of the functional testing system 87 preferably performs the following actions:
1. mount the tested product 16 and connects it to the activation devices and the measurement devices;
2. select a testing procedure from a set of testing procedure obtained from the functional test planning system 86;
3. instruct the activation devices to provide the required stimuli and the measurement devices to record the response signals according to the selected test procedure; and
4. instruct the computer 95 to verify that the measured response signal is within the permissible values of the reference signal (signature) provided by the functional test planning system 86 for the selected test.

The functional test planning system 11 and the functional testing system 12 as well as the functional test planning system 86 and the functional testing system 87 can be adapted to any type of product by selecting the appropriate activation devices and measuring devices. The functional test planning system 11 and the functional testing system 12 as well as the functional test planning system 86 and the functional testing system 87 are further described hereinbelow with respect to testing of electronic circuit boards.

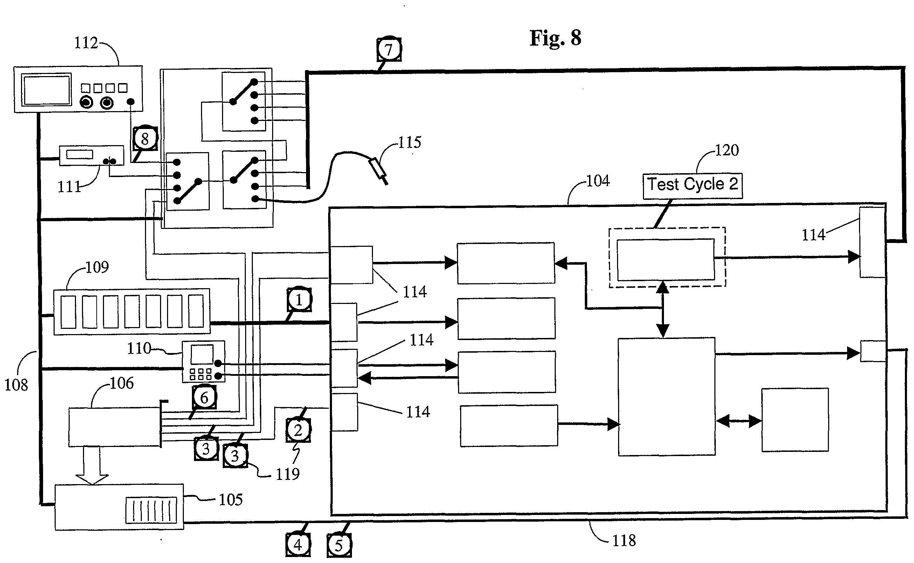

Reference is now made to Fig. 8, which is a simplified illustration of a preferred embodiment of the present invention for testing an electronic circuit board 104. Fig. 8 shows selected activation devices and measuring devices connected to a the electronic circuit board 104 and controlled by a computer 105, which may be any of the functional test planning system 11, the functional testing system 12, the functional test planning system 86 or the functional testing system 87.

In Fig. 8 the computer 105 controls a multi input/output (MI/O) computer card 106, typically mounted inside the computer 107, and via a communication link 108, a power supply 109, a signal generator 110, a multimeter 111 and an oscilloscope 112. The power supply, the signal generator and the output ports of the MI/O serve as activation devices while the input ports of the MI/O, the multimeter and the oscilloscope serve as measuring devices. The computer also control a switching device 113. The power supply, the signal generator and the output ports of the MI/O are connected directly to input ports 114 of the electronic circuit board 104 while the oscilloscope, the multimeter and a probe 115 connect to output ports 116 of the electronic circuit board 104 via the switching device 117. The computer also connects directly to the electronic circuit board 104 via a communication link 118, such as an RS232.

For each response signal measured by the functional test planning system 86 the user selects an algorithm to convert the response signal into a reference signal (reference signature). The algorithm creates a range of permissible values that is associated with the measured value. For example, if the measured value is 1Volt, the user can select a range of ±0.1 Volt, or ±10%, around the value of 1 Volt. The functional test planning system 86 provides the user with a graphical user interface (GUI) enabling the user to select from a variety of algorithms and manipulate the required permissible range without having to write code.

A preferred simplified process of creating a test procedure for the electronic circuit board of Fig. 8 is presented below:
1. Using the information provided by the FTCAM:
   a. The user identifies input and output and their connection to the on board connectors, and their technical description.
   b. The user selects the required test and measurement devices from the list of available devices.
   c. The user accesses documentation data, drawings and schematics pertaining to the unit under test.
   d. The user defines the expected specifications (numeric or strings) for the identified inputs and outputs
2. The system draws a functional test environment diagram as shown in Fig. 8.
3. Using a graphic editor, the user edits the functional test environment diagram s follows:
   a. Adding unit under test's block diagram and functional in board connections.
   b. Editing names and notes on the wires and equipment represented by icons.
   c. Editing switching logic and adding probes for interconnection monitoring.
4. Using the functional test environment diagram, the user can define sub tests cycles as follows:
   a. By setting a step serial number on the wires or bundles, such as referenced by numeral 119.
   b. By marking the tested block on the unit under test's block diagram, such as referenced by numeral 120.
   c. Setting or editing the test instruments soft panels some of the testing tools setups will be generated automatically, regarding simulation data or net names.
   d. Editing test algorithms, parameters and specifications
5. The user can now edit the test tree as follows:
   a. Editing the activation devices setups
   b. Editing the measuring devices setups
   c. Editing the expected measured data.
   d. Adding messages and delay time.
   e. Adding logical conditions such as GOTO, Stop and Loop subject to the expected Go /No-Go results.
   f. Editing the sub-test names.
6. The user can now view and edit additional data provided by the system, such as:
   a. Schematics of the connection harness, which are based on generic panels.
   b. Test environment hardware drawings and documentation.

Reference is now made to Figs. 9, 10 and 11, taken together, comprise a list of preferred algorithms for converting response signals into reference signals. The algorithms in the table of Fig. 9 are divided into three groups:
1. Basic Analysis - algorithms that provide a reconstruction of a physical signal.
2. Statistical Analysis - algorithms that identify deviations of the response signal from the reference signal.
3. Two Sources Analysis - algorithms that compare two response signals, mostly from different but inter-related sources, for examples two oscilloscope channels.

The algorithms of the table in Fig. 9 can also be divided into the following three types of measurements: one dimensional, two dimensional and three dimensional:
1. One dimensional measurement
   i. Minimum - the response signal should be equal or higher then the reference signal to comply with the functional requirements.
   ii. Maximum - the response signal should be equal or lower then the reference signal to comply with the functional requirements.
   iii. Exact - the response signal should be equal to the reference signal to comply with the functional requirements. Useful with measurements such as text, where the measured text should be identical to the reference text.
**2. Two Dimensional Measurements**
   (e.g. amplitude & time, frequency & time, etc.)
   i. Cyclic
      a. Rise time - the time it takes for a pulse or transition waveform to rise from a low value to a high value, such as element 121 in Fig. 10.
      b. Fall time - the time it takes for a pulse or transition waveform to fall from a high value to a low value, such as element 122 in Fig. 10.
      c. Low - specifies the level at which a pulse or transition waveform is defined to be in its lowest state, such as element 123 in Fig. 10.
      d. High - specifies the level at which a pulse or transition waveform is defined to be in its highest state, such as element 124 in Fig. 10.
      e. Min peak - the lowest measured value of the response signal such as a waveform.
      f. Max peak - the highest measured value of the response signal such as a waveform.
      g. Duty cycle - also known as duty factor, calculated by dividing the duration of a pulse by the duration of the period in which the pulse is repeated. The pulse duration can refer to the high or low portion of the period, depending on whether polarity is selected as high pulse or low pulse, usually expressed as a percentage value.
      h. Frequency - the number of times a waveform repeats in one second.
      i. Pulse width - the duration of one cycle of the pulse
      j. Amplitude - the difference between the high value and the low value of a waveform.
      k. RMS - root mean square, the effective value an AC waveform. In electrical terms, the AC RMS value is equivalent of the DC heating value of a particular waveform - voltage or current.
      l. Average - the average value of a sequence of specific measurements.
      m. Cycle count - the number of repeated waveform cycles in an array.
      n. Offset (two waves) - the time difference between two phenomena, such as the beginning of two waveforms.
      o. Overshoot - the difference between the local maximum and the amplitude (125 in Fig. 11) divided by the amplitude (126 in Fig. 11) and expressed as a percentage value.
      p. Undershoot - the difference between the local minimum and the amplitude (127 in Fig. 11) divided by the amplitude (126 in Fig. 11) and expressed as a percentage value.
   ii. Non cyclic
      a. Envelope - a permissible range of values around a two-dimensional response signal obtained from the approved product instance.
      b. Cross Correlation- a permissible range of values, in one dimension (X or Y), around a two-dimensional response signal obtained from the approved product instance.
      c. Histogram - a statistical analysis of the frequency of measurement values.
         1. Peak maximum (Y) - the value of the highest bin in the histogram.
         2. Peak count - the number of local peak counts.
         3. Integral - the area under the histogram.
         4. Max peak position (X) -the bin value of the bin of the peak maximum.
         5. Min peak position (X)- the bin value of the bin of the peak minimum
         6. Histogram envelop - a permissible range of values around histogram.
      d. Minimum - the minimum value of the envelope
      e. Maximum - the maximum value of the envelope
      f. Deviation - the standard deviation of the envelope
      g. Linear approximation - the linear function that is best fit to the envelope.
      h. Peak Detect - X and Y values of a certain peak of the envelope.
      i. Peak count - the number of peaks in a range.

### 3. Three Dimensional Measurements

E.g. amplitude, such as brilliance, over a surface
i. Topography
   a. Envelope - a permissible range of values around a three dimensional response signal obtained from the approved product instance
   b. Minimum - the minimum value of a three-dimensional response signal
   c. Maximum - the maximum value of a three-dimensional response signal.
   d. Average - the average value of a three-dimensional response signal.
   e. Deviation - the standard deviation of a three-dimensional response signal.
   f. Area Deviation
ii. Picture
   a. Histogram - a statistical analysis of the frequency of gray levels or colors in a picture.
   b. Uniformity - picture uniformity, an estimation of the quality of the illumination of a picture or the optical path.
   c. Noise ratio - the ratio between the noise level and the signal level, (measured in two states of light and darkness)
   d. MTF - a measure of the quality of a picture obtained by calculating the number of pixels in a transfer from light to dark.
   e. Pattern recognition - visual comparison between a test picture and a reference picture.
   f. OCR - optical character recognition, matching a visual text or number to a reference text or number. A number can vary within a range of a reference value.

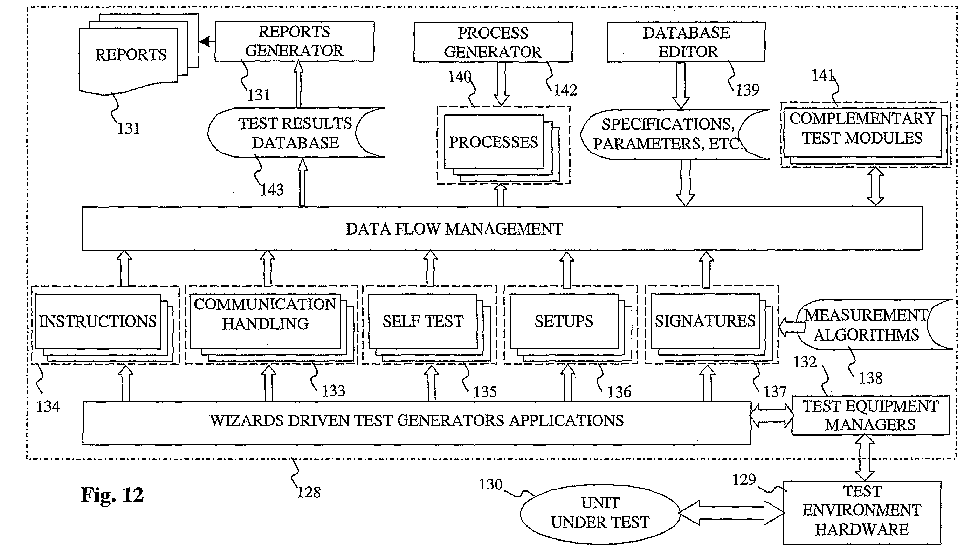

Reference is now made to Fig. 12, which is a simplified block diagram of the software 128 for a functional testing system according to a preferred embodiment of the present invention. The software 128 manages the test environment hardware 129, comprising a computer, activation devices, measuring devices and a mount for the tested product, to test or to troubleshoot a manufactured product 130, termed here "unit under test", and issue reports 131.

Element 132 of Fig. 12 is an equipment management module. The purpose of this module is to provide an adaptation and interface for:
i. Testing instruments, using a library of low level drivers (not shown).
ii. Graphical User Interface, for controlling the activation and the measurement devices using soft panels.
iii. Test manager environment database.

The activation and measuring devices are connected to the main computer using one of the standard communication protocols such as GPIB, RS232, USB or inserted directly into the computer using interfaces such as PCI, VXI and PXI. Each type of testing instruments has its own Software driver.

Element 133 of Fig. 12 is responsible for managing these communication facilities and contains communication protocol, instruments control logic, "Soft Panel" display, self test tools and necessary algorithms for examination of its measurement capabilities such as single measures, charts or graphs, text, binary files. The user can further establish a communication moitor to provide communications with the unit under test by initializing and managing test procedures, by using communication module test editor, as follows:
i. Set communication protocol parameters for the tool, such as: protocol type (RS232, USB, IEEE 1394) port address, format, baudrate, etc.
ii. Activate functions in the unit under test by sending digital data.
iii. Receive and record the response of the unit under test.
iv. Monitor the communication transmissions.

To support non-standard communication protocols, the module supports additional set of tools allowing the user to create low level drivers for the required communication link.

Element 134 of Fig. 12 provides instructions to the user when the user's involvement in the test process is required. On some occasions operator's interference is needed, during the test process. The Instruction editor module enables the user to create test applications using the following tools:
i. Instruction editor.
ii. Decision / indication buttons editor.
iii. Link to picture, media or other file.
iv. Parameters table editor.

Element 135 of Fig. 12 provides self-test of the test equipment when the test equipment itself has to be tested to ensure equipment functionality. The self-test module provides indications when testing instrument exists, when it is turned on, when it communicates with the main computer, etc. The self-test editor module enables the user to create self-test procedures using following features:
i. Selecting from a list all the equipment participating in a given test process.
ii. Selecting type of test (communication, self test or other)
iii. Activating instrument soft panels.
iv. Activating linked information related to the selected tool.

Element 136 of Fig. 12 provides setup instructions for the equipment, when the equipment has to be initialized before starting the test process. A selection is made of a communication test to test the communication with the unit under test 130. The test process requires testing instruments to be set with certain initialized or other conditions during different process stages. From time to time these conditions has to be changed during the test process based on testing requirements. To set and control these conditions, the setup generator editor module supports the following features:
i. Selection of the needed instruments from a list of available instruments.
ii. Activation and control of instrument's soft panel.
iii. Editing instrument setup and initialization table.
iv. Saving settings in the database.

Element 137 of Fig. 12 provides a set of test procedures to obtain response signals and convert them into reference signatures.

The objective of this module is to create a reference signature that represents the behavior of a physical phenomenon by a codeless, wizard driven, application. During the test program generation process, the system creates sets of reference files containing signatures of the desired test results, as they are recorded from an approved unit under test, and edited by the user by adding production tolerances. While testing a new product, the system compares the measured results of every test or sub-test to the relevant reference signatures and consequently sends an alarm to the user in every case of failure. Each signature type test is divided into sub-test modules that represent a basic test cycle.

The signature module contains the following features:
i. Display one or several of the product's related drawings, pictures, schematics, block diagrams, life video windows, component layout or other executable display files.
ii. Graphically highlight areas of the displayed objects and link them to the related sub-tests. During the test, the highlighted area is preferably blinking and at end of the test the highlighted color changes to red or green according to a "pass" (GO) or "fail" (NO-GO) results.
iii. Communication with PDM or ERP systems for the purpose of retrieving product's related information.
iv. Selection, communication and setup of testing instruments to generate inputs and measure outputs (power, current, pulses, waves, temperature, etc.) of the tested product.
v. Raw data measurement and analysis by a range of specific algorithms 138, test parameters and Specification settings.
vi. Generating instruction pop-up windows with links to text and visual data.
vii. Enabling delays between sub-tests or instrument activations.
viii. Adding "GOTO Sub-test number" logic and "number of loops" activated by test or sub-test result logic.
ix. Setting the following sub-test "modes" :
   1. Auto mode:
      Automatically start the sub-test and go to next sub-test at the test end.
   2. Run until Go: the sub test runs in a loop until test results reach certain specifications. Mostly used in debugging procedures, when operator using a probe.
   3. Run until NOGO: the sub test runs in a loop until it's out of predefined specifications. Mostly used testing stability of certain functions.
   4. Run step by step: All the above modes executed in a "step by step" mode and triggered by an operator decision it will go to next task.
x. Sound settings: the system supports designation of a sound related to a specific function performed by the system or to testing results. Especially useful for debugger that needs to concentrate on working with the unit under test, while expecting a "pass" or a "fail" sound indications.
xi. The combination of all or some of the abovementioned functions creating the test or sub-test cycle. This cycle is presented in a tree format containing all the necessary information to be used as test documentation. If necessary, the data tree can be edited and adjusted to meet the new requirements.

Element 139 of Fig. 12 is a database editor, operative to enable the user to edit the signature tests.

Signature tests are executed three ways:
In stand-alone mode a single test process is executed with a GO or a NOGO indication.
In troubleshooting mode all test controls and indicators are active and the user monitors the unit under test behavior.
In process mode where the process module 140 providing conditional logic applied for the test results.

In addition to tests built by test generator, Test Generator can activate and control any other application (figure 6. module 9) as exe, dll, vi, active-x, TCL and other formats on standard communication platforms.

As an open system, the test manager can execute any external complimentary tests 141 written in standard formats like exe, dll, vi, llb, active-x, TCL etc. These tests are being integrated and supported by controlling parameters, editing specification tables, handling results, executing processes, linking documentation, applying controls in "run mode", etc.

Element 142 of Fig. 12 is a process generator, providing the user with tools to build complex test processes and procedures: The process builder creates the order of tests and adds logic linked to tests or test results. The other purpose of this module is to execute procedures such as final test, run-out, stability, trouble shutting, preventing maintenance, etc., while guiding the user during the process and summarizing test results with reports. The following is a list of the main functions supported by process builder:
i. Adding to a new test process to any existing tests, sub-tests or elements of tests and their properties available in the database.
ii. Single tests conditions :
   1. number of test loops.
   2. delays before and/or after the test.
   3. display tests front panel.
   4. running tests serially or in parallel to other test switch.
iii. "On Start" single tests condition:
   1. display of a message box and its editor.
   2. display linked documents.
   3. automatically or manually starting the test.
iv. "On Go" or on "Fail" single tests conditions:
   1. process termination.
   2. display of a message box and its editor.
   3. display linked documents.
   4. automatically or manually terminating the test.
   5. adding test results to report.
   6. adding graphical elements to report.
   7. "GoTo" function, controlling logic and number of test loops.
v. Additional test types and conditions handling mathematical or logical manipulation of test parameters and results.
vi. All the abovementioned capabilities creating the process building function. For display and documentation purposes, these functions, conditions and their results are being displayed in a tree, table or flow chart formats and can by accessed by external systems.
vii. When necessary, the test tree can be reedited by:
   1. Moving single test or sub-test order up or down in test cycle.
   2. Deleting or adding the test from/to the tree.

Element 143 of Fig. 12 is a test results database. This is an additional database in which all test results are stored. Preferably, the test results database is a standard database and supports access by external software packages for purposes of off-line analysis.

Element 144 of Fig. 12 is a report generator providing the following functions:
- Report builder: Tool to configure report formats. The report is displayed automatically at the end of test process.
- Report display window has several options:
   1. Zooming selected line.
   2. Printing report.
   3. Saving the report in HTML or Excel formats.
- Report history: Allows to display process execution report by selecting S.N. and/or date & time and/or operator name of any tested UUT.
- Open architecture allowing external systems to retrieve data

The system also enables the user to enter administrative data before the testing is started, such as the product's Serial number, Batch number and the number of loops of all the process and to list all tests participating in the process, such as.
- Current test in process, its number of loops and current loop number.
- Number of process loops and its current loop number.
- Single tests result indication
- Last "GoTo" path.
- Test execution mode (monitor, auto, step by step, run until "Go" or "NoGo").

The system can be used for the planning and the execution of functional testing and for troubleshooting in any fields where functional assurance of a product at design, development, production or troubleshooting stages is required. The present invention, in various embodiments and configuration, is useful in the fields of electronics, mechanics, motion systems (Servo), optics, electricity, biotech, chemistry, automotive, communication, civil engineering, etc, provided that there is a need for testing functionality of any physical phenomenon that can be measured.

The present invention can be operated by R&D personnel, testing and quality control or production personnel during various stages of the product's lifecycles such as:
Products transfer from development to production.
Production quality control.
Product trouble shooting.
Engineering changes (ECO).
Maintenance and products diagnostics in the field.

The innovation supports testing and troubleshooting of parts, sub-assemblies, assembles and an entire system.

It is appreciated that certain features of the invention, which are, for clarity, described in the context of separate embodiments, may also be provided in combination in a single embodiment. Conversely, various features of the invention, which are, for brevity, described in the context of a single embodiment, may also be provided separately or in any suitable sub-combination.

Although the invention has been described in conjunction with specific embodiments thereof, it is evident that many alternatives, modifications and variations will be apparent to those skilled in the art. Accordingly, it is intended to embrace all such alternatives, modifications and variations that fall within the scope of the appended claims.

## Claims

1. A method for preparing a functional test for a manufactured product (130), said method comprising:
determining by means of a functional test computer aided manufacturing (FTCAM) system a test procedure (34) for said product according to design data for said product;
performing a process selected from at least one of:
(i) automatically inducing at least one selected stimulus to an approved instance of said product according to said test procedure, and automatically recording at least one response signal of said approved instance resulting from said at least one stimulus; and
(ii) creating a simulation of an input signal and a simulation of a response signal from at least one simulation tool according to said test procedure and said design data;
and
converting at least one of said recorded response signal and said simulation of said response signal into a reference specification.

2. The method of claim 1, further comprising:
selecting an input at said product for said automatically inducing at least one selected stimulus; and
selecting an output at said product for said automatically recording at least one response signal.

3. The method of claims 1 or 2, further comprising:
additionally performing at least one of inducing a stimulus or recording a response for said approved instance manually.

4. A method for performing functional testing, comprising:
performing the method of any of claims 1-3;
applying said at least one selected stimulus to a test instance of said product;
recording a response signal of said test instance of said product; and
comparing said response signal of said test instance of said product with said reference specification.

5. The method of claim 4, further comprising:
selecting an input at said test instance of said product for said applying said at least one selected stimulus; and
selecting an output at said test instance of said product for said automatically recording said response signal.

6. The method of claim 5, wherein said input comprises an electrical input and said output comprises an electrical output.

7. The method of claim 6, wherein said preparing said functional test further comprises:
selecting at least one activation device operative to produce said stimulus;
selecting a measurement device operative to measure said response signal;
providing mounting and wiring diagrams for connecting said test instance of said product to said activation device and to said measurement device.

8. The method of any of claims 1-6, further comprising:
selecting at least one activation device operative to produce said stimulus; and
selecting a measurement device operative to measure said response signal.

9. The method of any of claims 1-8 wherein said converting said response signal into said reference specification comprises selecting a predefined conversion function.

10. The method of any of claims 1-9 wherein said reference specification comprises a range of values associated with said response signal.

11. The method of any of claims 1-10 wherein said reference specification is associated with said response signal using at least one of: low amplitude value, high amplitude value, minimum peak value, maximum peak value, mean value, rise time, fall time, root mean square value of a series of amplitude values, duty cycle, overshoot, undershoot, peak to peak value, pulse count; cross correlation between at least two values of said response signal, values within specific range of said response signal, an integral of said response signal, fast Fourier transform of said response signal, permissible values within specific range of said response signal, distortion; peak detection; peak count; histogram, linear approximation; phase difference; amplitude difference; and frequency difference, amplitude measurements and frequency measurements.

12. The method of any of claims 4-11 wherein said testable instance of said product is faulty and said functional testing is arranged to guide a user to locate a fault.

13. A functional testing system (86,87) operative to test a manufactured product, said functional testing system comprising:
at least one activation device (92) operative to induce at least one selected stimulus on an approved instance of said product (88);
at least one measuring device (93) operative to measure and record at least one response signal of said instance resulting from said at least one stimulus;
a signal converter (91) operative to convert said recorded response signal into a reference specification;
at least one activation device (21) operative to induce at least one selected stimulus on a testable instance of said product (16);
at least one measuring device (22) operative to measure and record at least one response signal of said testable instance (16) resulting from said at least one stimulus; and
a comparator (12) operative to compare said at least one response signal of said testable instance (16) with said reference specification.

14. The functional testing planning system of claim 13, further comprising:
a graphical user interface operative to enable a user to perform the following functions:
select an input of said product for inducing a stimulus to said product;
select an output at said product for measuring a response signal of said product to said stimulus;
select said at least one said activation device operative to produce said stimulus; and
select said at least one said measurement device operative to measure said response signal.

15. The system of claims 13 or 14 wherein said signal converter is operative to convert said response signal into said reference specification using a predefined conversion function.

16. The system of any of claims 13-15 wherein said reference specification comprises a range of values associated with said response signal.

17. The system of any of claims 13-16 wherein said reference specification is associated with said response signal using at least one of: low amplitude value, high amplitude value, minimum peak value, maximum peak value, mean value, rise time, fall time, root mean square value of a series of amplitude values, duty cycle, overshoot, undershoot, peak to peak value, pulse count; cross correlation between at least two values of said response signal, values within specific range of said response signal, an integral of said response signal, fast Fourier transform of said response signal, permissible values within specific range of said response signal, distortion; peak detection; peak count; histogram, linear approximation; phase difference; amplitude difference; and frequency difference, amplitude measurements and frequency measurements.

## Patentansprüche

1. Verfahren zum Vorbereiten einer Funktionsprüfung für ein hergestelltes Produkt (130), das Verfahren umfassend:
Bestimmen eines Prüfverfahrens (34) für das Produkt mittels eines Systems einer Funktionsprüfung für rechnergestützte Fertigung (FTCAM) entsprechend den Konstruktionsdaten für das Produkt;
Ausführung eines Prozesses, ausgewählt aus mindestens einem von Folgenden:
(i) automatisches Induzieren mindestens eines ausgewählten Stimulus auf ein zugelassenes Exemplar des Produkts gemäß dem Prüfverfahren und automatisches Aufzeichnen mindestens eines Antwortsignals des zugelassenen Exemplars, das aus dem mindestens einen Stimulus resultiert; und
(ii) Erzeugen einer Simulation eines Eingangssignals und einer Simulation eines Antwortsignals von mindestens einem Simulationstool gemäß dem Prüfverfahren und den Konstruktionsdaten; und
Umwandeln des mindestens einen des aufgezeichneten Antwortsignals und/oder der Simulation des Antwortsignals in eine Referenzspezifikation.

2. Verfahren nach Anspruch 1, ferner umfassend:
Auswählen eines Eingangs an dem Produkt für das automatische Induzieren mindestens eines ausgewählten Stimulus; und
Auswählen eines Ausgangs an dem Produkt für das automatische Aufzeichnen mindestens eines Antwortsignals.

3. Verfahren nach Anspruch 1 oder 2, ferner umfassend:
zusätzliches Ausführen mindestens eines von Induzieren eines Stimulus oder manuellem Aufzeichnen einer Antwort für das zugelassene Exemplar.

4. Verfahren zum Ausführen von Funktionsprüfung, umfassend:
Ausführung des Verfahrens nach einem der Ansprüche 1-3;
Anwenden des mindestens einen ausgewählten Stimulus auf ein Prüfexemplar des Produkts;
Aufzeichnen eines Antwortsignals des Prüfexemplars des Produkts; und
Vergleichen des Antwortsignals des Prüfexemplars des Produkts mit der Referenzspezifikation.

5. Verfahren nach Anspruch 4, ferner umfassend:
Auswählen eines Eingangs an dem Prüfexemplar des Produkts für das Anwenden des mindestens einen ausgewählten Stimulus; und
Auswählen eines Ausgangs an dem Prüfexemplar des Produkts zum automatischen Aufzeichnen des Antwortsignals.

6. Verfahren nach Anspruch 5, wobei der Eingang einen elektrischen Eingang umfasst und der Ausgang einen elektrischen Ausgang umfasst.

7. Verfahren nach Anspruch 6, wobei das Vorbereiten der Funktionsprüfung ferner Folgendes umfasst:
Auswählen mindestens einer Aktivierungsvorrichtung, die funktionsfähig ist, um den Stimulus zu erzeugen;
Auswählen einer Messvorrichtung, die funktionsfähig ist, um das Antwortsignal zu messen;
Bereitstellen von Montage- und Verdrahtungsplänen zum Verbinden des Prüfexemplars des Produkts mit der Aktivierungsvorrichtung und mit der Messvorrichtung.

8. Verfahren nach einem der Ansprüche 1-6, ferner umfassend:
Auswählen mindestens einer Aktivierungsvorrichtung, die funktionsfähig ist, um den Stimulus zu erzeugen; und
Auswählen einer Messvorrichtung, die funktionsfähig ist, um das Antwortsignal zu messen.

9. Verfahren nach einem der Ansprüche 1-8, wobei das Umwandeln des Antwortsignals in die Referenzspezifikation ein Auswählen einer vordefinierten Umwandlungsfunktion umfasst.

10. Verfahren nach einem der Ansprüche 1-9, wobei die Referenzspezifikation einen Wertebereich umfasst, der mit dem Antwortsignal assoziiert ist.

11. Verfahren nach einem der Ansprüche 1-10, wobei die Referenzspezifikation unter Verwendung von mindestens einem von Folgenden mit dem Antwortsignal assoziiert ist:
niedrigem Amplitudenwert, hohem Amplitudenwert, minimalem Spitzenwert, maximalem Spitzenwert, Mittelwert, Anstiegszeit, Abfallzeit, quadratischem Mittelwert einer Reihe von Amplitudenwerten, Tastverhältnis, Überschwingen, Unterschwingen, Spitze-Spitze-Wert, Impulszählung; Kreuzkorrelation zwischen mindestens zwei Werten des Antwortsignals, Werten innerhalb eines bestimmten Bereichs des Antwortsignals, einem Integral des Antwortsignals, schneller Fourier-Transformation des Antwortsignals, zulässigen Werten innerhalb eines bestimmten Bereichs des Antwortsignals, Verzerrung; Spitzenerfassung; Spitzenzählung; Histogramm, linearer Annäherung; Phasendifferenz; Amplitudendifferenz; und Frequenzdifferenz, Amplitudenmessungen und Frequenzmessungen.

12. Verfahren nach einem der Ansprüche 4-11, wobei das prüfbare Exemplar des Produkts fehlerhaft ist und die Funktionsprüfung angeordnet ist, um einen Benutzer zum Auffinden eines Fehlers anzuleiten.

13. Funktionsprüfungssystem (86,87), das funktionsfähig ist, um ein hergestelltes Produkt zu prüfen, das Funktionsprüfungssystem umfassend:
mindestens eine Aktivierungsvorrichtung (92), die funktionsfähig ist, um mindestens einen ausgewählten Stimulus auf ein zugelassenes Exemplar des Produkts (88) zu induzieren;
mindestens eine Messvorrichtung (93), die funktionsfähig ist, um mindestens ein Antwortsignal des Exemplars, das aus dem mindestens einen Stimulus resultiert, zu messen und aufzuzeichnen;
einen Signalwandler (91), der funktionsfähig ist, um das aufgezeichnete Antwortsignal in eine Referenzspezifikation umzuwandeln;
mindestens eine Aktivierungsvorrichtung (21), die funktionsfähig ist, um mindestens einen ausgewählten Stimulus an einem prüfbaren Exemplar des Produkts (16) zu induzieren;
mindestens eine Messvorrichtung (22), die funktionsfähig ist, um mindestens ein Antwortsignal des prüfbaren Exemplars (16), das aus dem mindestens einen Stimulus resultiert, zu messen und aufzuzeichnen; und
einen Komparator (12), der funktionsfähig ist, um das mindestens eine Antwortsignal des prüfbaren Exemplars (16) mit der Referenzspezifikation zu vergleichen.

14. Funktionsprüfungs-Planungssystem nach Anspruch 13, ferner umfassend:
eine grafische Benutzeroberfläche, die funktionsfähig ist, um einem Benutzer zu ermöglichen, die folgenden Funktionen auszuführen:
Auswählen eines Eingangs des Produkts zum Induzieren eines Stimulus auf das Produkt;
Auswählen eines Ausgangs an dem Produkt zum Messen eines Antwortsignals des Produkts auf den Stimulus;
Auswählen der mindestens einen Aktivierungsvorrichtung, die funktionsfähig ist, um den Stimulus zu erzeugen; und
Auswählen der mindestens einen Messvorrichtung, die funktionsfähig ist, um das Antwortsignal zu messen.

15. System nach Anspruch 13 oder 14, wobei der Signalwandler funktionsfähig ist, um das Antwortsignal unter Verwendung einer vordefinierten Umwandlungsfunktion in die Referenzspezifikation umzuwandeln.

16. System nach einem der Ansprüche 13-15, wobei die Referenzspezifikation einen Wertebereich umfasst, der mit dem Antwortsignal assoziiert ist.

17. System nach einem der Ansprüche 13-16, wobei die Referenzspezifikation unter Verwendung von mindestens einem von Folgenden mit dem Antwortsignal assoziiert ist:
niedrigem Amplitudenwert, hohem Amplitudenwert, minimalem Spitzenwert, maximalem Spitzenwert, Mittelwert, Anstiegszeit, Abfallzeit, quadratischem Mittelwert einer Reihe von Amplitudenwerten, Tastverhältnis, Überschwingen, Unterschwingen, Spitze-Spitze-Wert, Impulszählung; Kreuzkorrelation zwischen mindestens zwei Werten des Antwortsignals, Werten innerhalb eines bestimmten Bereichs des Antwortsignals, einem Integral des Antwortsignals, schneller Fourier-Transformation des Antwortsignals, zulässigen Werten innerhalb eines bestimmten Bereichs des Antwortsignals, Verzerrung; Spitzenerfassung; Spitzenzählung; Histogramm, linearer Annäherung; Phasendifferenz; Amplitudendifferenz; und Frequenzdifferenz, Amplitudenmessungen und Frequenzmessungen.

## Revendications

1. Procédé de préparation d'un essai fonctionnel pour un produit manufacturé (130), ledit procédé comprenant :
la détermination au moyen d'un système de fabrication assistée par ordinateur d'essai fonctionnel (FTCAM) d'une procédure d'essai (34) pour ledit produit en fonction des données de conception pour ledit produit ;
l'exécution d'un processus choisi parmi au moins l'une de :
(i) l'induction automatique d'au moins un stimulus choisi dans une instance approuvée dudit produit en fonction de ladite procédure d'essai, et l'enregistrement automatique d'au moins un signal de réponse de ladite instance approuvée résultant dudit au moins un stimulus ; et
(ii) la création d'une simulation d'un signal d'entrée et d'une simulation d'un signal de réponse à partir d'au moins un outil de simulation en fonction de ladite procédure d'essai et desdites données de conception ;
et
la conversion d'au moins l'un dudit signal de réponse enregistré et de ladite simulation dudit signal de réponse en une spécification de référence.

2. Procédé selon la revendication 1, comprenant en outre :
la sélection d'une entrée au niveau dudit produit pour ladite induction automatique d'au moins un stimulus choisi ; et
la sélection d'une sortie au niveau dudit produit pour ledit enregistrement automatique d'au moins un signal de réponse.

3. Procédé selon la revendication 1 ou 2, comprenant en outre :
l'exécution en outre d'au moins une opération parmi l'induction d'un stimulus ou l'enregistrement manuel d'une réponse pour ladite instance approuvée.

4. Procédé d'exécution d'essai fonctionnel, comprenant :
l'exécution du procédé selon l'une quelconque des revendications 1 à 3 ;
l'application dudit au moins un stimulus choisi à une instance d'essai dudit produit ;
l'enregistrement d'un signal de réponse de ladite instance d'essai dudit produit ; et
la comparaison dudit signal de réponse de ladite instance d'essai dudit produit à ladite spécification de référence.

5. Procédé selon la revendication 4, comprenant en outre :
la sélection d'une entrée au niveau de ladite instance d'essai dudit produit pour ladite application dudit au moins un stimulus choisi ; et
la sélection d'une sortie au niveau de ladite instance d'essai dudit produit pour ledit enregistrement automatique dudit signal de réponse.

6. Procédé selon la revendication 5, ladite entrée comprenant une entrée électrique et ladite sortie comprenant une sortie électrique.

7. Procédé selon la revendication 6, ladite préparation dudit essai fonctionnel comprenant en outre :
la sélection d'au moins un dispositif d'activation servant à produire ledit stimulus ;
la sélection d'un dispositif de mesure servant à mesurer ledit signal de réponse ;
la fourniture de schémas de montage et de câblage pour connecter ladite instance d'essai dudit produit audit dispositif d'activation et audit dispositif de mesure.

8. Procédé selon l'une quelconque des revendications 1 à 6, comprenant en outre :
la sélection d'au moins un dispositif d'activation servant à produire ledit stimulus ; et
la sélection d'un dispositif de mesure servant à mesurer ledit signal de réponse.

9. Procédé selon l'une quelconque des revendications 1 à 8, ladite conversion dudit signal de réponse en ladite spécification de référence comprenant la sélection d'une fonction de conversion prédéfinie.

10. Procédé selon l'une quelconque des revendications 1 à 9, ladite spécification de référence comprenant une plage de valeurs associées audit signal de réponse.

11. Procédé selon l'une quelconque des revendications 1 à 10, ladite spécification de référence étant associée audit signal de réponse à l'aide d'au moins un élément parmi : une valeur d'amplitude faible, une valeur d'amplitude élevée, une valeur de crête minimale, une valeur de crête maximale, une valeur moyenne, un temps de montée, un temps de descente, une valeur quadratique moyenne d'une série de valeurs d'amplitude, un cycle de fonctionnement, un dépassement, un sous-dépassement, une valeur crête à crête, un nombre d'impulsions ; une corrélation croisée entre au moins deux valeurs dudit signal de réponse, des valeurs dans une plage spécifique dudit signal de réponse, une intégrale dudit signal de réponse, une transformée de Fourier rapide dudit signal de réponse, des valeurs admissibles dans une plage spécifique dudit signal de réponse, une distorsion ; une détection de crête ; un nombre de crêtes ; un histogramme, une approximation linéaire ; une différence de phase; une différence d'amplitude ; et une différence de fréquence, des mesures d'amplitude et des mesures de fréquence.

12. Procédé selon l'une quelconque des revendications 4 à 11, ladite instance testable dudit produit étant défectueuse et ledit essai fonctionnel étant conçu pour guider un utilisateur afin de localiser un défaut.

13. Système d'essai fonctionnel (86, 87) servant à tester un produit manufacturé, ledit système d'essai fonctionnel comprenant :
au moins un dispositif d'activation (92) servant à induire au moins un stimulus choisi sur une instance approuvée dudit produit (88) ;
au moins un dispositif de mesure (93) servant à mesurer et enregistrer au moins un signal de réponse de ladite instance résultant dudit au moins un stimulus ;
un convertisseur de signal (91) servant à convertir ledit signal de réponse enregistré en une spécification de référence ;
au moins un dispositif d'activation (21) servant à induire au moins un stimulus choisi sur une instance testable dudit produit (16) ;
au moins un dispositif de mesure (22) servant à mesurer et enregistrer au moins un signal de réponse de ladite instance testable (16) résultant dudit au moins un stimulus ; et
un comparateur (12) servant à comparer ledit au moins un signal de réponse de ladite instance testable (16) à ladite spécification de référence.

14. Système de planification d'essai fonctionnel selon la revendication 13, comprenant en outre :
une interface utilisateur graphique servant à permettre à un utilisateur d'exécuter les fonctions suivantes :
la sélection d'une entrée dudit produit pour induire un stimulus audit produit ;
la sélection d'une sortie au niveau dudit produit pour mesurer un signal de réponse dudit produit audit stimulus ;
la sélection dudit au moins un dit dispositif d'activation servant à produire ledit stimulus ; et
la sélection dudit au moins un dit dispositif de mesure servant à mesurer ledit signal de réponse.

15. Système selon les revendications 13 ou 14, ledit convertisseur de signal servant à convertir ledit signal de réponse en ladite spécification de référence à l'aide d'une fonction de conversion prédéfinie.

16. Système selon l'une quelconque des revendications 13 à 15, ladite spécification de référence comprenant une plage de valeurs associées audit signal de réponse.

17. Système selon l'une quelconque des revendications 13 à 16, ladite spécification de référence étant associée audit signal de réponse à l'aide d'au moins un élément parmi : une valeur d'amplitude faible, une valeur d'amplitude élevée, une valeur de crête minimale, une valeur de crête maximale, une valeur moyenne, un temps de montée, un temps de descente, une valeur quadratique moyenne d'une série de valeurs d'amplitude, un cycle de fonctionnement, un dépassement, un sous-dépassement, une valeur crête à crête, un nombre d'impulsions ; une corrélation croisée entre au moins deux valeurs dudit signal de réponse, des valeurs dans une plage spécifique dudit signal de réponse, une intégrale dudit signal de réponse, une transformée de Fourier rapide dudit signal de réponse, des valeurs admissibles dans une plage spécifique dudit signal de réponse, une distorsion ; une détection de crête ; un nombre de crêtes ; un histogramme, une approximation linéaire ; une différence de phase; une différence d'amplitude ; et une différence de fréquence, des mesures d'amplitude et des mesures de fréquence.
